## Europäisches Patentamt
## European Patent Office
## Office européen des brevets

(19)

(11) Numéro de publication: **0 128 823**
**B1**

(12)
# FASCICULE DE BREVET EUROPEEN

(45) Date de publication du fascicule du brevet:
**07.01.87**

(51) Int. Cl.⁴: **G 01 R 31/08**

(21) Numéro de dépôt: **84401156.9**

(22) Date de dépôt: **06.06.84**

(54) **Procédé et dispositif de détermination d'un paramètre associé à une ligne électrique en défaut, utilisant un signal pilote composite.**

(30) Priorité: **09.06.83 FR 8309559**

(43) Date de publication de la demande:
**19.12.84 Bulletin 84/51**

(45) Mention de la délivrance du brevet:
**07.01.87 Bulletin 87/2**

(84) Etats contractants désignés:
**CH DE GB LI SE**

(56) Documents cités:
**FR - A - 1 436 596**
**FR - A - 1 566 425**
**US - A - 3 369 156**
**US - A - 3 593 124**
**US - A - 4 251 766**

(73) Titulaire: **ENERTEC, 12 Place des Etats Unis,
F-92120 Montrouge (FR)**

(72) Inventeur: **Souillard, Michel, 16, rue des Fauvettes,
F-92260 Fontenay Aux Roses (FR)**

(74) Mandataire: **Bentz, Jean-Paul, GIERS SCHLUMBERGER
Service BREVETS 12, place des Etats-Unis,
F-92124 Montrouge Cedex (FR)**

## Description

La présente invention concerne un procédé et un dispositif pour déterminer, en un point de mesure d'une ligne de transport d'énergie électrique en défaut, notamment d'une ligne triphasée, un paramètre de défaut tel que la distance entre le point de mesure et ce défaut ou la direction de ce défaut, consistant: à produire des signaux de mesure instantanés de tension et de courant pour cette ligne, dont la résistance et l'inductance linéiques sont connues; à former, sur le schéma de la loi d'Ohm appliquée à la ligne, des combinaisons de ces signaux avec au moins une grandeur liée à une impédance, chaque combinaison utilisant un signal pilote représentatif du courant de défaut; et à donner audit paramètre la valeur pour laquelle un ensemble d'au moins une des ces combinaisons vérifie la loi d'Ohm.

Des procédés de ce type et des dispositifs pour leur mise en oeuvre sont connus et quelques exemples en sont donnés dans les brevets français FR 1 436 596, FR 1 566 425, et dans les brevets américains US 3 369 156, US 3 593 124 et US 4 251 766.

Dans les formes les plus classiques de ces techniques antérieures, la loi d'Ohm est appliquée à la ligne en défaut supposée en antenne, et exclusivement résistive et inductive. Il en résulte une équation incorporant les deux inconnues que sont d'une part la résistance du défaut et d'autre part la distance séparant ce défaut du point de mesure et cette équation est utilisée pour déterminer un ou plusieurs paramètres de défaut.

Par exemple, la détermination de la distance du défaut pour une ligne triphasée peut être obtenue en observant la loi d'Ohm pour deux ensembles de signaux de mesure de tension et de courant correspondant à des instants de mesure différents et en utilisant comme signal pilote, représentatif du courant de défaut, un courant proportionnel au courant homopolaire et en phase avec lui.

Ces procédés connus, qui donnent des résultats satisfaisants dans des conditions favorables, présentent cependant l'inconvénient d'un manque de sensibilité du signal pilote utilisé, notamment dans certains configurations de réseaux. En particulier, on a découvert que suivant la structure du réseau et les valeurs relatives des impédances homopolaire et inverse des sources aux extrémités d'une ligne en défaut, les courants homopolaire ou inverse pouvaient tendre vers zéro à une extrémité de la ligne. Il en résulte, dans la détermination des paramètres de défaut, des imprécisions qui, dans des conditions défavorables, peuvent devenir gênantes.

Dans ce contexte, le but de la présente invention est de proposer un procédé et un dispositif de détermination de paramètre de défaut qui, sans présenter une complexité sensiblement supérieure à celle des procédés et dispositifs connus précédemment mentionnés, présentent par rappaort à ceux-ci une meilleure précision.

Le procédé conforme à l'invention est essentiellement caractérisé en ce que le signal pilote utilisé pour représenter le courant de défaut est constitué par une combinaison linéaire d'un signal représentatif du courant homopolaire et d'un signal représentatif du courant inverse; le dispositif de l'invention comprend des moyens pour former cette combinaison linéaire.

Dans le cas d'un défaut entre une phase de la ligne et la terre, le signal pilote est de préférence proportionnel à la somme d'un signal représentatif du courant homopolaire et du double d'un signal représentatif du courant inverse associé à la phase en défaut.

Dans le cas d'un défaut entre les deux premières des trois phases d'une ligne triphasée, le signal pilote est de préférence proportionnel à la somme d'un signal représentatif du courant homopolaire et du double d'un signal représentatif du courant inverse associé à la troisième desdites phases et déphasé de 90° par rapport à cette somme.

D'autres caractéristiques et avantages de l'invention ressortiront de la description qui en est faite ci-après, à titre indicatif et nullement limitatif, en référence aux dessins annexés, dans lesquels:

la figure 1 est un schéma d'une portion de ligne en défaut;

et la figure 2 est un schéma du dispositif de l'invention dans le cas d'une mesure de distance d'un défaut entre la phase «a» et la terre dans une ligne triphasée.

De façon traditionnelle, la ligne électrique 1 comporte à chacune de ses extrémités un relais 2, 3 utilisant pour la détermination des paramètres de défaut des signaux de mesure de tension V(t) et de courant I(t) apparaissant à chaque instant sur la ligne au point d'implantation de ce relais, ou point de mesures M1, M2.

Un relais installé sur une ligne polyphasée utilise à chaque instant autant de signaux de mesure de tension et de courant (par exemple 3 signaux $V_a(t)$, $V_b(t)$, $V_c(t)$ de tension, et 3 signaux $I_a(t)$, $I_b(t)$, $I_c(t)$ de courant) que la ligne comporte de phases.

Conformément aux techniques connues pour déterminer un paramètre de défaut tel que la direction, par rapport au point de mesure, de l'emplacement de ce défaut, la zone dans laquelle il se trouve, la distance x le séparant du point de mesure ou la résistance électrique auquel il correspond, le procédé de l'invention fait application de la loi d'Ohm, à laquelle la ligne en défaut, dont on connaît au moins la résistance et l'inductance linéiques R et L, est supposée obéir.

Dans les techniques antérieures qui tiennent compte de la résistance du défaut $R_d$, l'hypothèse est généralement faite que le courant instantané dans le défaut I (t), est identique, en phase et en amplitude, à une combinaison des courants apparaissant au point de mesure; cette dernière hypothèse concerne par exemple le courant homopolaire dans le cas d'un défaut phase-terre d'une ligne polyphasée.

Ainsi, ces procédés connus conduisent à la formulation générale suivante de la loi d'Ohm appliquée à une ligne monophasée:

$$V = x \cdot R \cdot I + x \cdot L \cdot \frac{dI}{dt} + R_d \cdot I \qquad (1)$$

où V et I sont respectivement les signaux de mesure de tension et de courant élaborés par le relais, x la distance du défaut; et $\frac{dI}{dt}$ la dérivée temporelle du si-

gnal de mesure de courant. On voit que cette expression combine les signaux de mesure V et I avec des grandeurs $x \cdot R$, $x \cdot L$, et $R_d$ dont les deux premières sont reliées aux résistance R et inductance L linéiques de la ligne.

Les grandeurs physiques V et I étant connues à chaque instant, il en est de même pour la grandeur $\dfrac{dI}{dt}$.

Par exemple, la mesure de la distance x peut être obtenue dans les procédés connus en observant la loi d'Ohm à un instant $t_o$ tel que $I(t_o) = 0$; comme le courant de défaut est alors supposé nul, la résistance du défaut n'intervient plus dans l'équation et la distance du défaut est donnée par:

$$x = V(t_o) / [R \cdot I(t_o) + L \cdot \frac{dI}{dt}(t_o)]$$

c'est-à-dire encore:

$$x = V(t_o) / L \cdot \frac{dI}{dt}(t_o)$$

Des considérations équivalentes prévalent dans les procédés antérieurs pour des défauts sur des lignes polyphasées.

Plus précisément, un défaut entre la phase «a» et la terre sur une ligne triphasée est traditionnellement analysé au moyen de la relation:

$$V_{an} = x[R \cdot I_a + L \cdot (dI_a/dt) + (L_o\text{-}L)(dI_o/dt)] + 3R_d \cdot I_o$$

dans laquelle $V_{an}$ est la tension de la boucle «an» au point de mesure; $I_a$ est le courant de la phase «a» au point de mesure; $L_o$ est l'inductance linéique homopolaire de la ligne; et $I_o$ est le courant homopolaire donné par:

$$I_o = (I_a + I_b + I_c)/3,$$

«b» et «c» étant les deux autres phases de la ligne; ainsi, pour un défaut monophasé, la détection de zone par rapport à une distance de référence X peut de façon connue être réalisée par comparaison des polarités des tensions:

$$V_{an} - X[R \cdot I_a + L \cdot (dI_a/dt) + (L_o\text{-}L)(dI_o/dt)] \tag{2}$$

$$\text{et} \qquad R \cdot I_a + L \cdot (dI_a/dt) + (L_o\text{-}L)(dI_o/dt)$$

au moment du passage à zéro du courant $I_o$.

De même, un défaut entre les phases «a» et «b» d'une ligne triphasée est traditionnellement analysé au moyen de la relation:

$$V_{ab} = x[R \cdot I_{ab} + L \cdot (dI_{ab}/dt)] + R_d \cdot I_{ab} \tag{3}$$

dans laquelle $V_{ab}$ est la tension de la boucle «ab» au point de mesure; et $I_{ab}$ est le courant de la boucle «ab» au point de mesure; ainsi, pour un défaut entre phases, la détection de zone par rapport à une distance de référence X peut de façon connue être réalisée par comparaison des polarités des tensions:

$$V_{ab} - X[R \cdot I_{ab} + L \cdot (dI_{ab}/dt)] \tag{4}$$

$$\text{et } [R \cdot I_{ab} + L \cdot (dI_{ab}/dt)] \tag{5}$$

au moment du passage à zéro du courant $I_{ab}$.

Dans ce contexte, l'amélioration apportée par l'invention consiste, pour déterminer la chute de tension dans le défaut, à ne plus faire application directe du signal de mesure de courant, tel que $I_o$ ou $I_{ab}$, en tant que signal de courant de défaut associé à la résistance $R_d$, mais à utiliser à la place, en tant que signal de courant de défaut associé à la résistance $R_d$, un signal pilote composite formé par une combinaison linéaire d'un signal représentatif du courant homopolaire et d'un signal représentatif d'un courant inverse.

On rappelle que le courant inverse $I_{ia}$ associé à la phase «a», et le signal le représentant, sont définis par l'expression:

$$I_{ia} = (1/3)(I_a + a^2 I_b + a\, I_c), \text{ dans laquelle:}$$

$$a = \exp(2 \cdot PI \cdot j/3), \text{ où } PI = 3 \cdot 1416$$

j représentant le nombre unitaire complexe pur.

Les expressions des courants inverses associés aux deux autres phases «b» et «c» s'obtiennent à partir de l'expression de $I_{ia}$ par permutation circulaire des indices «a», «b» et «c».

Ainsi, le signal pilote composite $I_p$ utilisé pour représenter le courant de défaut répond de façon générale à l'expression:

$$I_p = k_1 I_o + k_2 I_i,$$

dans laquelle $k_1$ et $k_2$ sont des constantes réelles ou imaginaires.

Plus précisément, pour un défaut monophasé, phase «a» à la terre, le signal pilote a la forme:

$$I_{pa} = k_1 I_o + k_2 I_{ia}, \text{ et de préférence la forme}$$

$$I_{pa} = I_o + 2 I_{ia}.$$

On peut montrer en effet que:

$$I_o + 2 I_{ia} = I_a - j \cdot (3)^{1/2} \cdot (I_b - I_c)/3,$$

de sorte que le signal $I_{pa}$ peut être obtenu de façon aisée à partir des signaux de mesure de courant $I_a$, $I_b$ et $I_c$, le nombre imaginaire j étant représentatif d'un déphasage de 90° qui, de façon connue, peut-être obtenu par intégration ou différenciation.

Toutefois le signal pilote $I_{pa}$ relatif à la phase «a» pourrait être modifié en proportion relative de $I_o$ et de $I_{ia}$ par addition d'un terme proportionnel au courant homopolaire $I_o$; par exemple on pourrait donner à $I_{pa}$ la valeur $I_{pa} = k_o I_o + 2 I_{ia}$.

Les signaux pilotes $I_{pb}$ et $I_{pc}$ utilisables pour des défauts monophasés à la terre relatifs aux phases «b» et «c» respectivement répondent à des expressions analogues, obtenues par permutation circulaire des indices «a», «b» et «c».

Pour un défaut biphasé relatif aux phases «b» et «c», un signal pilote utilisable est par exemple $I_{pbc} = j \cdot (3)^{1/2} \cdot (I_o + 2 I_{ia})$.

On montre en effet que:

$j \cdot (3)^{1/2} \cdot (I_o + 2 I_{ia}) = I_b - I_c + j \cdot (3)^{1/2} \cdot I_a$

de sorte que $I_{pbc}$ peut être obtenu aisément à partir des signaux de mesure de courant $I_a$, $I_b$ et $I_c$.

Toutefois le signal pilote $I_{pbc}$ relatif aux phases «b» et «c» pour un défaut biphasé pourrait être modifié en proportion relative de $I_o$ et de $I_{ia}$ par addition d'un terme proportionnel au courant homopolaire $I_o$.

A la limite, par exemple, un signal pilote $I'_{pcb} = j \cdot 2 \cdot (3)^{1/2} \cdot I_{ia}$, indépendant du courant homopolaire $I_o$, serait utilisable aussi bien pour le défaut biphasé «bc» isolé que pour le défaut biphasé «bc» à la terre pour lequel il existe un couplage de la phase «a» par rapport au défaut «bcn» et où il existe un courant de terre égal à 3 $I_o$.

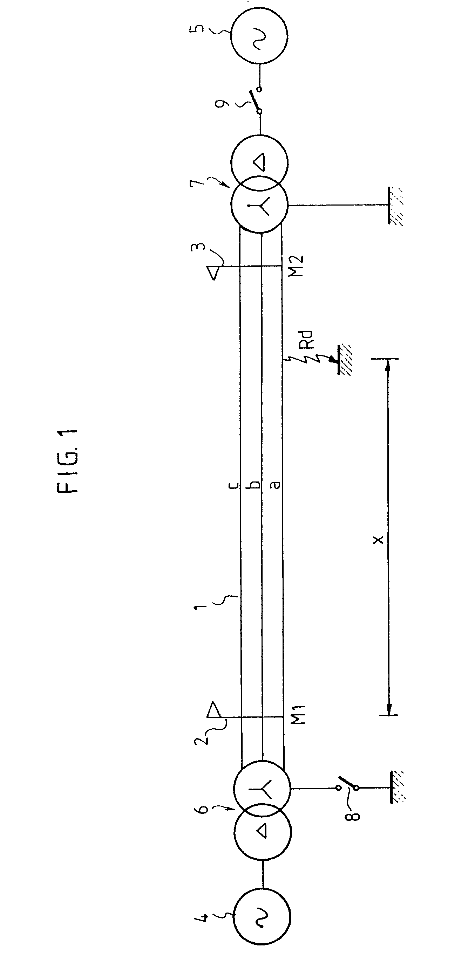

Outre les éléments déjà décrits, la figure 1 représente deux générateurs 4 et 5 disposés chacun à une extrémité de la ligne 1, ainsi que des transformateurs 6 et 7 respectifs les reliant à cette ligne. Un interrupteur 8 relie le transformateur 6 à la terre et un interrupteur 9 relie la source 5 au transformateur 7.

La position ouverte de ces interrupteurs donne un exemple extrême de dissymétrie avec, en $M_1$, une impédance homopolaire infinie et un courant homopolaire nul et, en $M_2$, une impédance inverse infinie et un courant inverse nul.

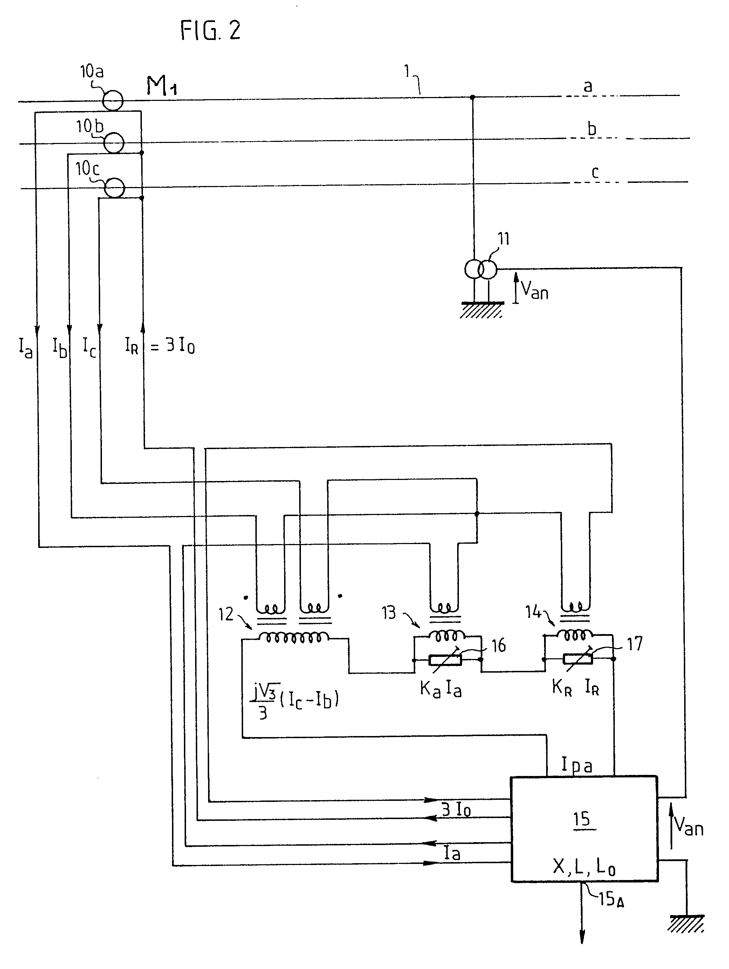

La figure 2 illustre, de façon schématique, un dispositif mettant en oeuvre le procédé de l'invention dans le cas d'un défaut entre la phase «a» et la terre (défaut an) d'une ligne triphasée.

Des transformateurs de courant $10_a$, $0_b$, $10_c$ associés à la ligne 1 au point d'implantation $M_1$ du relais 2 délivrent les signaux de mesure $I_a$, $I_b$, $I_c$, ainsi que le signal

$I_R = I_a + I_b + I_c = 3 I_o$.

Un transformateur de tension 11 délivre le signal de mesure de tension $V_{an}$ donnant le potentiel de la phase «a» par rapport à la terre.

Le signal pilote $I_{pa}$ est formé dans un circuit comprenant en série les secondaires d'une inductance mutuelle 12 et des transformateurs 13 et 14.

La mutuelle inductance 12 comprend, au primaire, deux enroulements inverses respectivement parcourus par les courants $I_b$ et $I_c$. Le secondaire commun développe donc une tension proportionnelle à la différence $I_c - I_b$ et déphasé de 90° par rapport à $I_b - I_c$. Le coefficient de mutuelle inductance peut être adapté pour être égal à $(3)^{-1/2}$.

Le transformateur 13 comprend, au primaire, un enroulement parcouru par un courant $I_a$ et, au secondaire, un enroulement débitant sur une résistance variable 16 développant une tension proportionnelle $K_a I_a$.

Le transformateur 14 comprend, au primaire, un enroulement parcouru par le courant $I_R = 3 I_o$ et, au secondaire, un enroulement débitant sur une résistance variable 17 développant une tension proportionnelle $K_R \cdot I_R$.

Le signal $I_{pa}$, correspondant à la tension développée dans le circuit série des secondaires des transformateurs 12, 13 et 14, est ainsi égal à:

$K_a I_a + K_R I_R - j \cdot (3)^{-1/2} \cdot (I_b - I_c)$,

et par exemple à $(3K_R + 1)I_o + 2I_{ia}$ si $K_a = 1$.

Le signal pilote $I_{pa}$, ainsi que les signaux 3 $I_o$ (ou $I_o$), $I_a$ et $V_{an}$ sont adressés à une untié de traitement et de mesure 15 connue en elle-même, disposant des informations nécessaires sur les paramètres X, L et $L_o$, et susceptible de fournir sur sa sortie $15_A$ une information de défaut par comparaison de la polarité des tensions données par les équations (2) ci-dessus au moment du passage à zéro du signal pilote $I_{pa}$.

De nombreux autre exemples de mise en oeuvre de l'invention pourraient être donnés; toutefois la description qui en est faite ci-dessus permettra à l'homme de l'art de les établir sans difficulté en se référant au fait que l'invention revient toujours à utiliser, comme signal de courant de défaut associé à la résistance $R_d$, un signal pilote composite formé par une combinaison linéaire d'un signal représentatif du courant homopolaire et d'un signal représentatif d'un courant inverse.

Ainsi, pour prendre un nouvel exemple, le procédé évoqué ci-dessus en référence aux équations (4) et (5) consisterait, selon l'invention, à comparer les polarités des tensions:

$V_{ab} - X [R \cdot I_{ab} + L \cdot (dI_{ab}/dt)]$

et $[R \cdot I_{ab} + L \cdot (dI_{ab}/dt)]$

au moment du passage à zéro du signal pilote $I_{pab}$, égal par exemple à $j \cdot (3)^{1/2} \cdot (I_o + 2I_{ic})$.

## Revendications

1. Procédé pour déterminer, en un point de mesure d'une ligne (1) de transport d'énergie électrique en défaut, notamment d'une ligne triphasée, un paramètre de défaut tel que la distance (x) entre le point de mesure et ce défaut ou la direction de ce défaut, consistant: à produire des signaux de mesure instantanés de tension et de courant pour cette ligne, dont la résistance (R) et l'inductance (L) linéiques sont connues; à former, sur le schéma de la loi d'Ohm appliquée à la ligne, des combinaisons de ces signaux avec au moins une grandeur liée à une impédance, chaque combinaison utilisant un signal pilote représentatif du courant de défaut; et à donner audit paramètre la valeur pour laquelle un ensemble d'au moins une de ces combinaisons vérifie la loi d'Ohm, caractérisé en ce que ledit signal pilote ($I_p$) représentatif du courant de défaut est constitué par une combinaison linéaire d'un signal représentatif du courant homopolaire ($I_o$) et d'un signal représentatif d'un courant inverse ($I_i$).

2. Procédé suivant la revendication 1, caractérisé en ce que ledit signal pilote est proportionnel à la somme d'un signal représentatif du courant homopolaire et du double d'un signal représentatif d'un courant inverse.

3. Procédé suivant la revendication 2, utilisable pour un défaut entre une phase de la ligne et la terre, caractérisé en ce que ledit signal pilote est proportionnel à la somme d'un signal représentatif du courant homopolaire et du double d'un signal représentatif du courant inverse associé à la phase en défaut.

4. Procédé suivant la revendication 2, utilisable pour un défaut entre les deux premières des trois phases d'une ligne triphasée, caractérisé en ce que ledit signal pilote est proportionnel à la somme d'un signal représentatif du courant homopolaire et du double d'un signal représentatif du courant inverse associé à la troisième desdites phases, et déphasé de 90° par rapport à cette somme.

5. Dispositif propre à déterminer, en un point de mesure d'une ligne de transport d'énergie électrique en défaut, notamment d'une ligne triphasée, un paramètre de défaut tel que la distance entre le point de mesure (M1) et ce défaut ou la direction de ce défaut, comprenant des premiers moyens (15) pour former des combinaisons de signaux de mesure instantanés de tension et de courant avec au moins une grandeur liée à une impédance, et pour donner audit paramètre la valeur pour laquelle un ensemble d'au moins une de ces combinaisons vérifie la loi d'Ohm, chaque combinaison utilisant un signal pilote représentatif du courant de défaut, caractérisé en ce qu'il comprend des seconds moyens (12, 13, 14, 16, 17) pour former un signal composite constitué par une combinaison linéaire d'un signal représentatif du courant homopolaire et d'un signal représentatif de courant inverse, et en ce que ce signal composite ($I_{pa}$) est appliqué auxdits premiers moyens pour constituer ledit signal pilote représentatif de courant de défaut.

**Claims**

1. A process for the determination, at a measurement point of a faulty electrical power transport line (1), especially a three-phase line, of a fault parameter such as the distance (x) between the measurement point and this fault or the direction of this fault, which comprises the steps of: generating instantaneous voltage and current measurement signals for said line, the resistance (R) and inductance (L) per unit length of which are known; forming, on the Ohm's law scheme applied to the line, combinations of such signals with at least one quantity related to an impedance, wherein each combination employs a pilot signal representative of the fault current, and assigning said parameter with the value for which a set of at least one of such combinations agrees with Ohm's law, characterized in that said pilot signal ($I_p$) representative of the fault current consists in a linear combination of a signal representative of the homopolar current ($I_o$) and a signal representative of a reverse current ($I_i$).

2. A process according to claim 1, wherein said pilot signal is proportional to the sum of a signal representative of the homopolar current and the double of a signal representative of a reverse current.

3. A process according to claim 2, which is applicable to a fault between one phase of the line and the ground, characterized in that said pilot signal is proportional to the sum of a signal representative of the homopolar current and the double of a signal representative of the reverse current associated with the faulty phase.

4. A process according to claim 2, which is applicable to a fault between the two first ones of the three phases of a three-phase line, characterized in that said pilot signal is proportional to the sum of a signal representative of the homopolar current and the double of a signal representative of the reverse current associated with the third one of said phases and phase-shifted by 90° relative to this sum.

5. A device for the determination, at a measurement point of a faulty electrical power transport line, especially a three-phase line, of a fault parameter such as the distance between the measurement point (M1) and this fault or the direction of this fault, which comprises first means (15) for forming combinations of instantaneous voltage and current measurement signals with at least one quantity related to an impedance, and assigning said parameter with a value for which a set of at least one of such combinations agrees with Ohm's law, wherein each combination employs a pilot signal representative of the fault current, characterized in that it comprises second means (12, 13, 14, 16, 17) for forming a composite signal consisting in a linear combination of a signal representative of the homopolar current and a signal representative of the reverse current, and in that this composite signal ($I_{pa}$) is applied to said first means to form said pilot signal representative of a fault current.

**Patentansprüche**

1. Verfahren zur an einem Messpunkt einer fehlerhaften elektrischen Stromtransportleitung (1), insbesondere Dreiphasenleitung, erfolgenden Bestimmung eines Fehlerparameters wie die Entfernung (x) zwischen dem Messpunkt und diesem Fehler oder die Richtung dieses Fehlers, darin bestehend, dass: Spannungs- und Strom-Augenblicksmesswertsignale für diese Leitung erzeugt werden, deren Linienwiderstand (R) und Linieninduktivität (L) bekannt sind; nach dem auf die Leitung angewandten Schema des Ohmschen Gesetzes Kombinationen dieser Signale mit wenigstens einer Grösse gebildet werden, welche mit einer Impedanz verknüpft ist, wobei in jeder Kombination ein Pilotsignal verwendet wird, welches repräsentativ für den Fehlerstrom ist; und dem genannten Parameter derjenige Wert gegeben wird, für welchen wenigstens eine Gruppe einer dieser Kombinationen das Ohmsche Gesetz erfüllt, dadurch gekennzeichnet, dass das genannte Pilotsignal ($I_p$) welches repräsentativ für den Fehlerstrom ist, durch eine Linearkombination eines für den gleichphasigen Strom ($I_o$) repräsentativen Signals mit einem für einen gegenphasigen Strom ($I_i$) repräsentativen Signal gebildet wird.

2. Verfahren nach Anspruch 1, dadurch gekennzeichnet, dass das genannte Pilotsignal proportional zur Summe eines für den gleichphasigen Strom repräsentativen Signals mit dem zweifachen Wert eines für einen invertierten Strom repräsentativen Signals ist.

3. Verfahren nach Anspruch 2, anwendbar auf einen Fehler zwischen einer Phase der Leitung und Masse, dadurch gekennzeichnet, dass das genannte Pilotsignal proportional zu der Summe eines Signals ist, welches repräsentativ für den invertierten Strom ist, der zu der fehlerhaften Phase gehört.

4. Verfahren nach Anspruch 2, anwendbar auf einen Fehler zwischen den beiden ersten der drei Phasen einer Dreiphasenleitung, dadurch gekennzeichnet, dass das genannte Pilotsignal proportional zur Summe eines für den gleichphasigen Strom repräsentativen Signals mit dem zweifachen Wert eines Signals ist, welches repräsentativ für den invertierten Strom ist, welcher zu der dritten dieser Phasen gehört und um 90° gegenüber dieser Summe phasenverschoben ist.

5. Vorrichtung zur an einem Messpunkt einer fehlerhaften elektrischen Stromtransportleitung, insbesondere einer Dreiphasenleitung, erfolgenden Bestimmung eines Fehlerparameters wie die Entfernung zwischen dem Messpunkt (M1) und diesem Fehler oder die Richtung dieses Fehlers, mit ersten Mitteln (15) zur Bildung von Kombinationen aus Spannungs- und Strom-Augenblicksmesswertsignalen mit wenigstens einer mit einer Impedanz verknüpften Grösse und zur Einstellung des genannten Parameters auf denjenigen Wert, für welchen eine Gruppe wenigstens einer dieser Kombinationen das Ohmsche Gesetz erfüllt, wobei in jeder Kombination ein Pilotsignal verwendet wird, welches repräsentativ für den Fehlerstrom ist, dadurch gekennzeichnet, dass sie zweite Mittel (12, 13, 14, 16, 17) umfasst, um ein zusammengesetztes Signal zu bilden, das durch eine Linearkombination eines für den gleichphasigen Strom repräsentativen Signals mit einem für den invertierten Strom repräsentativen Signal gebildet ist, und dass dieses zusammengesetzte Signal ($I_{pa}$) an die genannten ersten Mittel angelegt ist, um das genannte Pilotsignal zu bilden, welches für den Fehlerstrom repräsentativ ist.

FIG. 1

0 128 823

FIG. 2